# EUROPÄISCHE PATENTSCHRIFT

(11) **EP 3 204 960 B1**
(45) Veröffentlichungstag und Bekanntmachung des Hinweises auf die Patenterteilung: **02.05.2018**
(21) Anmeldenummer: 16801125.2
(22) Anmeldetag: 13.10.2016
(51) Int. Cl.: H01J 37/305

(54) **VERFAHREN ZUR BESTIMMUNG DER SICH VERÄNDERNDEN LAGE DES AUFTREFFPUNKTES EINES ENERGETISCHEN STRAHLES AUF EINER BEGRENZTEN FLÄCHE**
METHOD FOR DETERMINING THE CHANGING LOCATION OF THE POINT OF INCIDENCE OF AN ENERGETIC BEAM ON A DELIMITED SURFACE
PROCÉDÉ DE DÉTERMINATION DE LA POSITION VARIANTE DU POINT D'INCIDENCE D'UN FAISCEAU D'ÉNERGIE SUR UNE SURFACE LIMITÉE

(30) Priorität: 16.10.2015 DE 102015117693
(43) Veröffentlichungstag der Anmeldung: 16.08.2017
(73) Patentinhaber: Ald Vacuum Technologies GmbH, 63457 Hanau (DE)
(72) Erfinder: REITER, Georg, 63579 Freigericht (DE); WÄLZLEIN, Matthias, 63594 Hasselroth (DE)
(74) Vertreter: Hebing, Norbert
(86) Internationale Anmeldenummer: PCT/DE2016/100478
(87) Internationale Veröffentlichungsnummer: WO 2017/063642

(56) Entgegenhaltungen:
- DE-A1-102013 107 454
- US-A1- 2005 205 778

## Beschreibung

Die Erfindung bezieht sich auf ein Verfahren zur Bestimmung der sich verändernden Lage des Auftreffpunktes eines kontinuierlichen oder gepulsten energetischen Strahles auf einer begrenzten Fläche, der von einer Ablenkeinrichtung periodisch über die Fläche bewegt wird, wobei die Fläche mit einer Kamera erfasst wird, die eine Vielzahl von einzeln auswertbaren Bildpunkten in einer Bildebene aufweist, wobei jedem Punkt der Fläche ein Bildpunkt zugeordnet ist und wobei die von der Kamera erfassten Bildwerte mittels einer Bildanalyseeinrichtung ausgewertet werden.

In der US 2005/205778 wird ein System zur Kalibrierung der Auslenkung eines Laserstrahls beschrieben, mit dessen Hilfe Material von elektronischen Bauteilen entfernt wird, um deren Eigenschaften zu ändern. Zum Erkennen von Abbildungsfehlern wird eine Prüfkarte mit einem definierten Muster verwendet, was es erlaubt, die erkannten Abbildungsfehler auszugleichen.

Bei dem energetischen Strahl kann es sich z. B. um einen von einer Elektronenstrahlkanone erzeugten Elektronenstrahl handeln, der auf die Oberfläche einer Schmelze gerichtet ist, um dort Material zu verdampfen, das der Beschichtung von Bauteilen dient. Andere Verwendungen von energetischen Strahlen werden weiter unten erläutert. Um einen in der Fläche gleichmäßigen Energieeintrag zu erhalten, ist eine Ablenkeinrichtung vorgesehen, die den energetischen Strahl periodisch in einem vorgegebenen Muster über die Fläche bewegt. Der Strahl kann kontinuierlich oder gepulst betrieben werden, wobei für jeden Puls ein neuer Auftreffpunkt definiert ist, so dass sich ein periodisch wiederkehrendes Muster von Auftreffpunkten ergibt.

Da die Lage der zu erfassenden Fläche in Bezug auf die Elektronenstrahlkanone bekannt ist, kann die Ablenkeinrichtung so eingestellt werden, dass das Muster die gesamte begrenzte Fläche erfasst.

Allerdings hat sich gezeigt, dass sich aufgrund von äußeren Einflüssen Abweichungen vom eingestellten Soll-Muster ergeben. Da die Wirkungen der Einflüsse auf den Strahl nicht unbedingt reproduzierbar sind, können sie so nicht von vornherein in einer entsprechenden Steuerfunktion für die Ablenkeinrichtung berücksichtigt werden. Daher ist es notwendig, dem Bediener einer entsprechenden Apparatur ein Bild der Fläche zur Verfügung zu stellen, auf dem der wandernde Auftreffpunkt zu erkennen ist, bzw. das sich einstellende Muster. Erkennt der Bediener, dass der Weg des Auftreffpunktes von dem gewünschten Weg abweicht bzw. das Muster vom eingestellten Soll-Muster abweicht, kann er die Ablenkeinrichtung entsprechend nachjustieren.

In der DE 10 2008 009 410 B4 wird schon offenbart, diesen Vorgang zu automatisieren. Dazu wird eine Analyse vom Bild der vom Strahl überstrichenen Fläche vorgenommen und mit Hilfe der Bildanalyse der Weg des Auftreffpunktes mit dem Sollweg verglichen. Treten Abweichungen auf, erfolgt eine entsprechende automatische Nachjustierung der Ablenkeinrichtung.

Eine solche automatische Bildanalyse gestaltet sich aber schwierig, da z. B. die Oberfläche einer Schmelze sehr hell ist, so dass der Auftreffpunkt, obwohl er durch einen entsprechenden Energieeintrag eine höhere Helligkeit haben sollte als seine Umgebung, nur schwer zu erkennen ist, da sich seine Helligkeit nur wenig von der Helligkeit des Hintergrundes unterscheidet.

Zum Stand der Technik ist auch die DE 10 2013 107 454 A1 zu nennen, die sich ebenfalls damit beschäftigt, die Wanderung eines Elektronenstrahls über eine Fläche auf einem bestimmten Bereich, z. B. einer Schmelzenoberfläche, zu begrenzen. Dazu wird ein Sensor eingesetzt, der die Rückwirkungen des Auftreffens des Elektronenstrahls auf die abgetastete Fläche registriert. Bei diesen Rückwirkungen kann es sich um elektromagnetische Strahlung oder Sekundärelektronen handeln. Bei dem Sensor handelt es sich aber nicht um eine Kamera mit einer Vielzahl von Bildpunkten, die jeweils Flächenpunkten zugeordnet sind. Der Sensor nimmt die elektromagnetische Strahlung oder die Sekundärelektronen nicht in Bildpunkten gerastert auf, sondern als Einzelwert, der die Rückwirkung über die gesamte abgetastete Fläche mittelt.

Weiterhin zu berücksichtigen ist, dass Prozesse, bei denen energetische, insbesondere hochenergetische Strahlen eine Oberfläche abtasten, in einer gekapselten Vorrichtung erfolgen. Eine Kamera zur Bildanalyse wird aber außerhalb der Vorrichtung angeordnet und erhält das Bild der Fläche durch eine transparente Scheibe, die durch Ablagerungen von Dämpfen, die beim Abtasten der Fläche entstehen, die Bildintensität in einer nicht vorhersehbaren Weise verringert, so dass Helligkeitsunterschiede im Bild nicht mehr sicher einem Auftreffpunkt zuzuordnen sind.

Wenn in diesem Zusammenhang von einer Kamera gesprochen wird, kann es sich im Prinzip um eine Kamera handeln, die Licht im sichtbaren Wellenbereich, Infrarot oder einen noch anderen Frequenzbereich aufnimmt. Gemeint sind aber auch Bildaufnahmesysteme, die auf anderen physikalischen Prinzipien beruhen, wie sie weiter unten näher erläutert werden. Entscheidend ist aber, dass eine Abbildung der Fläche auf eine Bildebene in dem Bildaufnahmesystem erfolgt und dass die Bildpunkte der Bildebene einzeln erfasst werden, so dass sie einzeln ausgewertet werden können.

Vorzugsweise handelt es sich bei der Kamera aber um eine CCD-Kamera mit zweidimensionalen CCD-Array-Sensoren, wobei jeder einzelne CCD-Sensor der Arrays einen Bildpunkt repräsentiert.

Während ein geschulter Bediener einer entsprechenden Apparatur noch in der Lage sein wird, auch in einem schlechten Bild den Weg des Auftreffpunktes zu bestimmen und manuell entsprechende Konturen an der Ablenkeinrichtung vorzunehmen, ist es gerade für eine automatische Regelung notwendig, eine besonders verlässliche Bilderkennung durchzuführen, bei der der Weg des Auftreffpunktes und das so erzeugte Muster verlässlich identifiziert werden kann.

Die Erfindung beruht daher auf der Aufgabe, eine Bildanalyse zu schaffen, bei der verlässlich der Weg des Auftreffpunktes eines energetischen Strahls auf einer begrenzten Fläche identifiziert werden kann.

Dazu sieht die Erfindung vor, dass
die Bildanalyseeinrichtung für zumindest einige der Bildpunkte eine zeitliche Folge von Bildwerten ermittelt,
eine Signalanalyse der zeitlichen Folge der Bildwerte dieser Bildpunkte vorgenommen wird,
das Ergebnisse der Signalanalyse korreliert wird mit der von der Ablenkeinrichtung induzierten Periodizität und/oder der Periodizität des Strahlpulses,
und auf Grund der Güte der Korrelation bestimmt wird, ob der dem jeweiligen Bildpunkt zugeordnete Punkt der Fläche zu einen bestimmten Zeitpunkt vom dem energetischen Strahl getroffen worden ist.

Da der kontinuierliche oder gepulste Strahl von der Steuereinheit periodisch über die begrenzte Fläche bewegt wird, findet sich diese Periodizität auch in dem zeitlichen Verlauf der Bildwerte für einen Bildpunkt wieder. Dies bedeutet, dass sich für jeden Bildpunkt eine spezifische Bildwertvariation ergibt, die durch das periodisch wiederkehrende Auftreffen des Strahles auf den Flächenpunkt bestimmt wird. Betrachtet man nun den zeitlichen Verlauf der Bildwerte für einen Bildpunkt, kann man dessen Frequenzspektrum bestimmen und die Periodenfrequenz herausfiltern. Auf dies Weise werden einzelne helle Bildwerte, die aber auf andere Weise als durch das Auftreffen des Strahls hervorgerufen wurden, bei der Analyse unterdrückt.

Durch geeignete mathematische Methoden lässt sich daher bestimmen, ob die Bildwertfolge für das Auftreffen des Strahls charakteristisch ist, so dass, wenn eine Analyse für entsprechende weitere Bildpunkte vorgenommen wird, ein zeitlicher Verlauf der Wanderung des Auftreffpunktes auf der Fläche ermittelt werden kann. Dies kann sowohl für kontinuierliche Strahlen als auch für gepulste Strahlen erfolgen, wobei im letzteren Fall die Pulsfrequenz bei der Frequenzanalyse des zeitlichen Bildwerteverlaufs mit einfließen kann.

Vorzugsweise wird der kontinuierliche oder gepulste Strahl von einer Ablenkeinrichtung in einem sich mit einer Basisfrequenz periodisch wiederholenden Muster über die Fläche bewegt. In einem solchen Fall kann diese Basisfrequenz für die Analyse der Bildwertefolge herangezogen werden.

Dazu kann z. B. ein Spektrum des zeitlichen Verlaufs ermittelt werden, anschließend die Wiederholungsfrequenz des Musters herausgefiltert und in einen zeitlichen Verlauf zurück transformiert werden.

Neben der Basisfrequenz, mit der die Wiederholung des Musters beschrieben wird, befinden sich in dem Bild weitere Frequenzen, nämlich die Oszillationsfrequenzen, die sich aus den Frequenzspektren ergeben, mit denen der Strahl in den beiden Flächenrichtungen, die in der Regel senkrecht aufeinander stehen, abgelenkt wird. Auch diese Frequenzspektren können zur Analyse der Bildwertfolge herangezogen werden.

Die Erfindung sieht daher vor, dass der Strahl von einer Ablenkeinrichtung für jede der beiden Flächenrichtungen mit einem jeweils spezifischen Frequenzspektrum abgelenkt wird, wobei die Ergebnisse der Signalanalyse mit den spezifischen Frequenzspektren korreliert werden.

Eine weitere Frequenz, die zur Analyse der Bildwertfolge herangezogen werden kann, ist bei der Verwendung eines gepulsten Strahls dessen Pulsfrequenz.

Wie oben erwähnt, handelt es sich bei dem Strahl typischer Weise um einen Elektronenstrahl, der dazu dient, Material umzuschmelzen oder zu verdampfen. Insofern ist die begrenzte Fläche die Oberfläche einer Schmelze.

Denkbar wären aber auch die Beobachtungen von Röntgen-, Laser- oder Teilchenstrahlen. Laserstrahlen werden z. B. auch eingesetzt bei 3D-Druckern. Auch hier liegen zumindest abschnittsweise periodisch wiederkehrende Muster auf geraden oder gekrümmten Flächen vor, so dass die Erfindung auch geeignet ist zur Kontrolle eines dreidimensionalen Druckes.

Wie oben schon erwähnt, werden mit dem Auftreffen des Strahles bestimmte physikalische Prozesse auf dem Material, das die Fläche bildet, hervorgerufen. So werden bei einer Schmelze neben sichtbarem Licht auch Röntgenstrahlen und Teilchenstrahlen erzeugt, die vom Auftreffpunkt ausgehen. Diese können ebenfalls zur Darstellung eines Bildes unter Verwendung eines entsprechenden Bildaufnahmesystems herangezogen werden.

Wie oben erwähnt, dient das Verfahren nicht nur dazu, ein Bild darzustellen, auf dem der Weg des Auftreffpunktes über die Fläche sichtbar wird, um es so einen Bediener zu ermöglichen, entsprechende Nachstellungen an einer Ablenkeinrichtung vorzunehmen. Vielmehr kann das Verfahren auch so ergänzt werden, dass die gewonnene Information über den Weg des energetischen Strahles über die Fläche als Regelgröße in die Steuerung der Ablenkeinrichtung einfließt.

Da - wie erläutert - das vorgeschriebene Verfahren zur Bilderkennung eine sichere Identifizierung des Weges des Ablenkstrahles erlaubt, kann auch ein entsprechender Regelalgorithmus zur Steuerung der Ablenkeinrichtung eingerichtet werden, der nicht zu einer Fehleinstellung führt.

Eine Vorrichtung zur Durchführung des Verfahrens besteht vorzugsweise aus einem Tiegel zur Aufnahme einer Schmelze, einer Elektronenstrahlkanone, die auf den Tiegel gerichtet ist, einer mittels einer Steuereinrichtung steuerbaren Ablenkeinrichtung, die den Elektronenstrahl der Elektronen periodisch über die Oberfläche der Schmelze bewegt, einer Kamera, die in den Tiegel gerichtet ist und die eine Vielzahl von einzeln auswertbaren Bildpunkten in einer Bildebene aufweist, wobei jedem Punkt der Oberfläche ein Bildpunkt zugeordnet ist, und mit einer Bildanalyseeinrichtung, dadurch gekennzeichnet, dass die Bildanalyseeinrichtung so eingerichtet ist, dass die Periodizität der Strahlablenkung
zur Bildanalyse herangezogen wird, um die Auftreffpunkte im Bild zu identifizieren.

Die Vorrichtung kann ergänzt werden in dem Sinn, dass die Bildanalyseeinrichtung so eingerichtet ist, dass sie einen Korrekturwert an die Steuerung der Ablenkeinrichtung auszugeben vermag.

Im Folgenden soll anhand eines Ausführungsbeispiels die Erfindung näher erläutert werden. Dazu zeigen:
- Fig. 1: eine schematische Darstellung einer Vorrichtung mit einer Elektronenstrahlkanone und
- Fig. 2: den zeitlichen Verlauf der Bildwerte in einem Bildpunkt, wenn die Abtastung der Oberfläche in einem sich periodisch wiederholenden Muster erfolgt.

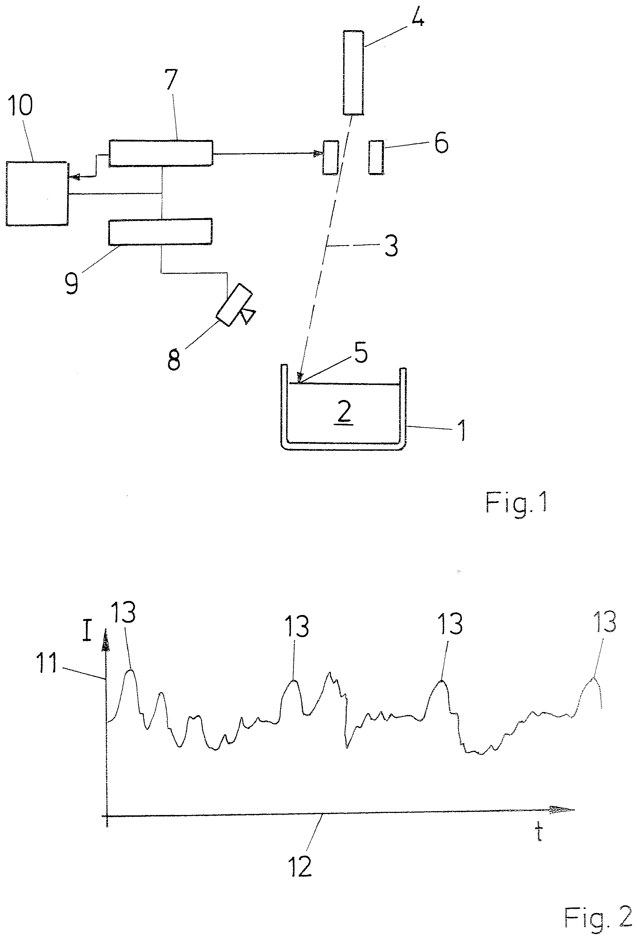

Bezug nehmend auf die Fig. 1 erkennt man, dass sich in einem Tiegel 1 eine Schmelze 2 befindet, auf deren Oberfläche der Elektronenstrahl 3 einer Elektronenkanone 4 gerichtet ist. Der Strahl 3 schmilzt das Material auf oder verdampft die Schmelze 2 im Bereich seines Auftreffpunktes 5. Das verdampfte Material trifft z. B. auf einen - hier nicht dargestellten - zu beschichtenden Körper. dabei handelt es sich z. B. um die Schaufel einer Turbine.

Um den Energieeintrag nicht auf eine bestimmte Position der Schmelzenoberfläche zu fokussieren, wird der Strahl 3 in einem sich wiederholenden Muster über die gesamte Oberfläche der Schmelze 2, die von der Tiegelwand begrenzt ist, bewegt. Dazu wird der Strahl 3 durch eine Ablenkeinrichtung 6, die aus sich senkrecht kreuzenden Elektromagneten besteht, in deren Felder die Elektronen abgelenkt werden, periodisch über die Fläche bewegt.

Die Ablenkeinrichtung 6 sieht für beide Flächenrichtungen jeweils eine gesonderte Ablenkeinheit vor, deren Elektromagneten von einer Steuereinheit 7 mit Strom beauftragt werden. Die Stärke des jeweiligen elektrischen Stromes bestimmt die Ablenkung des Elektronenstrahls 3 in X- und Y-Richtung. Die Ströme für die X- und Y-Richtung unterliegen jeweils einer bestimmten Periodizität und Phasenlage, so dass verschiedene Muster auf der Oberfläche erzeugt werden können.

Denkbar sind spiralförmige Muster, aber auch sprungzeilenförmige Muster. Jedenfalls wird sich das Muster nach einiger Zeit wiederholen. Diese Wiederholung wird mit einer Basisfrequenz beschrieben. Die Parameter für den zeitlichen Verlauf der Ablenkströme in X- und Y-Richtung werden zunächst manuell eingestellt.

Weiterhin existiert eine Kamera 8, die die Oberfläche der Schmelze 2 abbildet. Auf dem Kamerabild lässt sich mit einiger Erfahrung der jeweilige Auftreffpunkt 5 des Elektronenstrahls 3 erkennen und sein Weg über die schmelzende Oberfläche, so dass ein erfahrener Bediener erkennen kann, ob das durch den Weg gezeichnete Muster die Fläche gleichmäßig abdeckt und dem eingestellten Sollmuster entspricht.

Da die Schmelzoberfläche insgesamt eine hohe Helligkeit aufweist, ist die Identifizierung des Auftreffpunktes und seines Weges auf der Schmelzenoberfläche nicht einfach. Deswegen sieht die Erfindung ein Bildanalyseverfahren vor, bei dem die zeitlich aufeinander folgenden Bilder auf Periodizität, die durch die Einstellung der Ablenkeinrichtung vorgegeben ist, untersucht und analysiert werden. Dazu wird das Kamerabild einer Bildanalyseeinrichtung 9 zugeführt, in der das beanspruchte Verfahren implementiert ist. Das von der Kamera aufgenommene Bild kann außerdem auf einem Monitor 10 wiedergegeben werden.

Betrachtet man z. B. ein Bild, das zu einem bestimmten Oberflächenpunkt gehört, und trägt, wie im Diagramm der Fig. 2 gezeigt, den entsprechenden Bildwert (Y-Achse 11), also seine Lichtstärke über die Zeit (X-Achse 12) ab, so wird sich ein spezifischer Bildwert 13 oder eine Bildwertvariation und die jeweils zeitlich benachbarten Werte in der Basisfrequenz wiederholen. Da die Basisfrequenz bekannt ist, kann durch geeignete mathematische Methoden die Lichtstärke zu einem bestimmten Zeitpunkt eindeutig als das Auftreffen des Elektronenstrahls zurückgeführt werden und somit der spezifische Bildwert 13 bzw. die Bildwertvariation identifiziert werden.

Entsprechende Analysen können auch auf Basis der Oszillationsfrequenzen bzw. der Impulsfrequenz vorgenommen werden.

Des Weiteren können zeitliche Bildserien untersucht werden. Die Wanderung des Auftreffpunktes auf der Schmelzenoberfläche muss der Periodizität der Ablenkung in den verschiedenen Flächenrichtungen folgen oder Impulsspektrum enthalten, so dass auch die Untersuchung von zeitlichen Bildserien unter Berücksichtigung des Frequenzspektrums der Ablenkung für die beiden Flächenrichtungen Aufschluss darüber bringt, welche festgestellten Lichtstärken tatsächlich auf das Auftreffen eines Lichtstrahles zurückzuführen sind.

Die Analyse kann in einer Darstellung zusammengefasst werden, die das Muster, das vom Weg des Aufreffpunktes gezeichnet wird, als Ganzes wiedergibt, wobei die Gesamthelligkeit der Oberfläche unterdrückt wird. Eine solche Darstellung wird dem Bediener ebenfalls auf dem Monitor 10 präsentiert. Eine solche schematische Darstellung erlaubt eine bessere manuelle Nachjustierung der Ablenkeinrichtung 6.

Die Analyse kann aber auch in geeignete Parameter transformiert werden, die der Steuereinheit 7 zugeführt wird, so dass diese selbsttätig die Steuergrößen wie Amplitude, Frequenz und Phase der Ströme für die Ablenkeinheiten einstellt, so dass das tatsächliche Muster mit dem Sollmuster in Übereinstimmung gebracht wird. Es wird somit ein Regelkreis geschaffen.

### Bezugszeichenliste

- 1: Tiegel
- 2: Schmelze
- 3: Elektronenstrahl
- 4: Elektronenkanone
- 5: Auftreffpunkt

- 6: Ablenkeinrichtung
- 7: Steuereinheit
- 8: Kamera
- 9: Bildanalyseeinrichtung
- 10: Monitor

- 11: Y-Achse
- 12: X-Achse
- 13: spezifischer Bildwert

## Patentansprüche

1. Verfahren zur Bestimmung der sich verändernden Lage des Auftreffpunktes eines kontinuierlichen oder gepulsten energetischen Strahles auf einer begrenzten Fläche, der von einer Ablenkeinrichtung periodisch über die Fläche bewegt wird, mit den folgenden Schritten:
Erfassen der Fläche mit einer Kamera, die eine Vielzahl von einzeln auswertbaren Bildpunkten in einer Bildebene aufweist, wobei jedem Punkt der Fläche ein Bildpunkt zugeordnet ist,
Auswerten der von der Kamera erfassten Bildwerte mittels einer Bildanalyseeinrichtung,
**dadurch gekennzeichnet, dass**
die Bildanalyseeinrichtung für zumindest einige der Bildpunkte eine zeitliche Folge von Bildwerten ermittelt,
eine Signalanalyse der zeitlichen Folge der Bildwerte dieser Bildpunkte vorgenommen wird,
das Ergebnisse der Signalanalyse korreliert wird mit der von der Ablenkeinrichtung induzierten Periodizität und/oder der Periodizität des Strahlpulses,
und auf Grund der Güte der Korrelation bestimmt wird, ob der dem jeweiligen Bildpunkt zugeordnete Punkt der Fläche zu einen bestimmten Zeitpunkt vom dem energetischen Strahl getroffen worden ist.

2. Verfahren nach Anspruch 1, **dadurch gekennzeichnet, dass** der Strahl von einer Ablenkeinrichtung in einem sich mit einer Basisfrequenz periodisch wiederholenden Muster über die Fläche bewegt wird, wobei die die Ergebnisse der Signalanalyse mit der von der Basisfrequenz induzierten Periodizität korreliert werden.

3. Verfahren nach Anspruch 2, **dadurch gekennzeichnet, dass** der Strahl von einer Ablenkeinrichtung für jede der beiden Flächenrichtungen mit einem jeweils spezifischen Frequenzspektrums abgelenkt wird, wobei die die Ergebnisse der Signalanalyse mit den spezifischen Frequenzspektren korreliert werden.

4. Verfahren nach einem der vorhergehenden Ansprüche, **dadurch gekennzeichnet, dass** es sich bei dem energetischen Strahl um einen Elektronenstrahl handelt.

5. Verfahren nach einem der vorhergehenden Ansprüche, **dadurch gekennzeichnet, dass** es sich bei der Fläche um die Oberfläche einer Schmelze oder eines aufzuschmelzenden Materials handelt.

6. Verfahren nach einem der vorhergehenden Ansprüche, **dadurch gekennzeichnet, dass** die Bildwerte die Intensität der vom Auftreffpunkt ausgehenden elektromagnetischen Strahlung oder des vom Auftreffpunkt ausgehenden Teilchenstrahls wiedergeben.

7. Verfahren nach einem der vorhergehenden Ansprüche, **dadurch gekennzeichnet, dass** die aus dem Vergleich gewonnene Information über den Weg des energetischen Strahls über die Fläche als Regelgröße in die Steuerung der Ablenkeinrichtung einfließt.

8. Vorrichtung zur Durchführung eines Verfahrens nach einem der vorhergehenden Ansprüche, aufweisend einen Tiegel zu Aufnahme einer Schmelze, eine Elektronenstrahlkanone, die auf den Tiegel gerichtet ist, eine mittels einer Steuereinrichtung steuerbaren Ablenkeinrichtung, die den Elektronenstrahl der Elektronen periodisch über die Oberfläche einer sich im Tiegel befindenden Schmelze bewegt, einer Kamera, die in den Tiegel gerichtet ist und die eine Vielzahl von einzeln auswertbaren Bildpunkten in einer Bildebene aufweist, wobei jedem Punkt der Oberfläche ein Bildpunkt zugeordnet ist, und mit einer Bildanalyseeinrichtung, **dadurch gekennzeichnet, dass** die Bildanalyseeinrichtung so eingerichtet ist, dass die Periodizität der Strahlablenkung und/oder des Strahlpulses zur Bildanalyse herangezogen wird, um die Auftreffpunkte des Strahls in der Oberfläche im Bild zu identifizieren.

9. Vorrichtung nach Anspruch 8, **dadurch gekennzeichnet, dass** die Bildanalyseeinrichtung so eingerichtet ist, dass sie einen Korrekturwert an die Steuerung der Ablenkeinrichtung auszugeben vermag.

## Claims

1. A method for determining the changing location of the point of incidence of a continuous or pulsed energetic beam on a delimited surface that is periodically moved over the surface by a deflecting unit, comprising the following steps:
Detecting the surface with a camera having a plurality of individually evaluable pixels in an image plane, wherein each point of the surface is associated with a pixel,
Evaluating the image values detected by the camera by means of an image analysis device,
**characterized in that**
the image analysis device determines a temporal sequence of image values for at least some of the pixels,
a signal analysis of the temporal sequence of image values of these pixels is made,
the results of the signal analysis are correlated with the periodicity induced by the deflecting unit and/or the periodicity of the beam pulse,
and, based on the quality of the correlation, it is determined whether the point of the surface associated with the respective pixel has been hit by the energetic beam at a particular time.

2. Method according to claim 1, **characterized in that** the beam is moved over the surface by a deflecting unit in a pattern that repeats periodically at a base frequency, wherein the results of the signal analysis are correlated with the periodicity induced by the base frequency.

3. A method according to claim 2, **characterized in that** the beam is deflected by a deflecting unit for each of the two planar directions with a respectively specific frequency spectrum, the results of the signal analysis being correlated with the specific frequency spectra.

4. Method according to one of the preceding claims, **characterized in that** the energy beam is an electron beam.

5. Method according to one of the preceding claims, **characterized in that** the surface is the surface of a melt or a material to be melted.

6. Method according to one of the preceding claims, **characterized in that** the image values represent the intensity of the outgoing electromagnetic radiation from the point of incidence or the outgoing point particle beam from the point of incidence.

7. Method according to one of the preceding claims, **characterized in that** the information obtained on the path of the energetic beam over the surface flows into the control of the deflecting unit as a control variable.

8. Apparatus for carrying out a method according to one of the preceding claims, comprising a crucible for receiving a melt, an electron beam gun, which is directed onto the crucible, a deflecting unit controllable by means of a control device which moves the electron beam of the electrons periodically over a melt surface located in the crucible, a camera, which is directed into the crucible and has a plurality of individually evaluable pixels in an image plane, each point of the surface being assigned a pixel, and with an image analysis device, **characterized in that** the image analysis device is arranged so that the periodicity of the beam deflection and/or the beam pulse is used for image analysis to identify the points of incidence of the beam in the surface in the image.

9. Apparatus according to claim 8, **characterized in that** the image analysis device is adapted to output a correction value to the control of the deflecting unit.

## Revendications

1. Procédé pour la détermination de la position variante du point d'incidence d'un faisceau d'énergie continu ou pulsé sur une surface limitée, lequel est déplacé périodiquement sur la surface par un dispositif de déviation, avec les étapes suivantes :
la saisie de la surface avec une caméra qui présente une pluralité de points d'image analysables individuellement dans un plan d'image, dans lequel on associe un point d'image à chaque point de la surface,
l'analyse des valeurs d'image saisies par la caméra au moyen d'un dispositif d'analyse d'image,
**caractérisé en ce que**
le dispositif d'analyse d'image détermine, au moins pour certains des points d'image, une séquence chronologique de valeurs d'image,
l'on procède à une analyse de signaux de la séquence chronologique des valeurs d'image de ces points d'image,
des résultats de l'analyse de signaux sont corrélés avec la périodicité et/ou la périodicité de l'impulsion du faisceau induite par le dispositif de déviation,
et qu'en raison de la qualité de la corrélation, on détermine si le point de la surface associé au point d'image respectif a été touché à un moment déterminé par le faisceau d'énergie.

2. Procédé selon la revendication 1, **caractérisé en ce que** le faisceau est déplacé sur la surface par un dispositif de déviation selon un motif se répétant périodiquement avec une fréquence de base, dans lequel les résultats de l'analyse de signaux sont corrélés avec la périodicité induite par la fréquence de base.

3. Procédé selon la revendication 2, **caractérisé en ce que** le faisceau est dévié par un dispositif de déviation pour chacune des deux directions de surface avec un spectre de fréquences respectivement spécifique, dans lequel les résultats de l'analyse de signaux sont corrélés avec les spectres de fréquences spécifiques.

4. Procédé selon l'une des revendications précédentes, **caractérisé en ce que**, concernant le faisceau d'énergie, il s'agit d'un faisceau d'électrons.

5. Procédé selon l'une des revendications précédentes, **caractérisé en ce que**, concernant la surface, il s'agit de la surface d'une masse fondue ou d'un matériau de fusion.

6. Procédé selon l'une des revendications précédentes, **caractérisé en ce que** les valeurs d'image reflètent l'intensité du rayonnement électromagnétique partant du point d'incidence ou du faisceau de particules partant du point d'incidence.

7. Procédé selon l'une des revendications précédentes, **caractérisé en ce que** l'information, obtenue à partir de la comparaison, sur le trajet du faisceau d'énergie sur la surface alimente en tant que grandeur réglée la commande du dispositif de déviation.

8. Dispositif pour la mise en oeuvre d'un procédé selon l'une des revendications précédentes, présentant un creuset pour la réception d'une masse fondue, un canon à faisceau d'électrons dirigé sur le creuset, un dispositif de déviation pouvant être commandé au moyen d'un dispositif de commande, lequel déplace périodiquement le faisceau d'électrons des électrons sur la surface d'une masse fondue se trouvant dans le creuset, une caméra orientée vers l'intérieur du creuset et qui présente une pluralité de points d'image analysables individuellement dans un plan d'image, dans lequel on associe un point d'image à chaque point de la surface, et avec un dispositif d'analyse d'image, **caractérisé en ce que** le dispositif d'analyse d'image est étudié de manière à ce que la périodicité de la déviation du faisceau et/ou de l'impulsion du faisceau est prise en compte pour l'analyse d'image afin d'identifier, sur l'image, les points d'incidence du faisceau sur la surface.

9. Dispositif selon la revendication 8, **caractérisé en ce que** le dispositif d'analyse d'image est étudié de manière à ce qu'il soit en mesure de faire sortir une valeur de correction à l'attention de la commande du dispositif de déviation.
